Europäisches Patentamt

European Patent Office

Office européen des brevets

(19)

(11) Veröffentlichungsnummer: **0 219 848 B1**

# EUROPÄISCHE PATENTSCHRIFT

(12)

(45) Veröffentlichungstag der Patentschrift:
**16.01.91 Patentblatt 91/03**

(51) Int. Cl.[5] : **H04Q 3/52, H04Q 11/04,**
**H03K 19/094**

(21) Anmeldenummer: **86114552.2**

(22) Anmeldetag: **21.10.86**

(54) **Breitbandsignal-Raumkoppeleinrichtung.**

(30) Priorität: **22.10.85 DE 3537562**

(43) Veröffentlichungstag der Anmeldung:
**29.04.87 Patentblatt 87/18**

(45) Bekanntmachung des Hinweises auf die
Patenterteilung:
**16.01.91 Patentblatt 91/03**

(84) Benannte Vertragsstaaten:
**AT BE CH DE FR GB IT LI NL SE**

(56) Entgegenhaltungen:
**DE-A- 2 348 414**
**PATENT ABSTRACTS OF JAPAN, vol. 7, no. 40**
**(E-159)[1185], 17. Februar 1983; & JP-A-57 193**
**125**

(73) Patentinhaber: **Siemens Aktiengesellschaft**
**Wittelsbacherplatz 2**
**D-8000 München 2 (DE)**

(72) Erfinder: **Hofmann, Rüdiger, Dr.**
**Fürstenfelder Weg 12**
**D-8031 Gilching (DE)**

## Beschreibung

Neuere Entwicklungen der Fernmeldetechnik führen zu diensteintegrierenden Nachrichtenübertragungs- u. - vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-Kbit/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannt, jeweils zwei Leitungen mit Hilfe eines Gatterelements zu verbinden, das von einer als bistabiles D-Kippglied gebildeten koppelpunktindividuellen Speicherzelle ein- und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppenetzwerken für Breitband-Digitalsignale", Diss., Braunschweig 1978, Bild 6.7). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raumkoppeleinrichtungen bevorzugt, in denen die über die einzelnen Koppelpunkte durchgeschalteten Verbindungen allein räumlich voneinander getrennt sind.

Eine reine Breitbandsignal-Raumkoppelanordnung kann als Koppelpunktmatrix ausgebildet sein, in deren Koppelpunkten die Koppelelemente jeweils von einer lediglich decodergesteuerten koppelpunktindividuellen Halte-Speicherzelle gesteuert werden (siehe Pfannschmidt, a.a.O., Bild 6.4 ; Electronics/December 15, 1983, Seiten 88/89) ; die Koppelelemente können dabei jeweils als C-MOS-Transfergate (C-MOS-Transmissionsgate) ausgebildet sein (DE-A-2 348 414 ; ISS'84 Conference Papers 23CI, Fig.9). Die Verwendung eines einfachen C-MOS-Transfergates als Koppelelement ist indessen bei dessen Durchschaltezustand mit einer Belastung seiner Eingangsleitung durch die Kapazität seiner Ausgangsleitung verbunden, was Signalverzögerungen mit sich bringen kann ; außerdem kann es aufgrund von sog. Unterschwelleneffekten (z. B. in Form von Leckströmen oder Unterschwellenströmen) entlang der MOS-Transistoren zu Übersprecherscheinungen über an sich im Sperrzustand befindliche Koppelelemente hinweg kommen.

Die Erfindung stellt sich nun die Aufgabe, in einer Breitband-Raumkoppeleinrichtung einen Weg zu einer besonders zweckmäßigen Ausbildung der Koppelelemente aufzuzeigen, bei der die im vorstehenden angeführten Nachteile vermieden werden.

Die Erfindung betrifft eine Breitbandsignal-Raumkoppeleinrichtung mit einer Koppelpunktmatrix, deren jeweils von einer decodergesteuerten, koppelpunktindividuellen Speicherzelle steuerbaren Koppelelemente jeweils mit einem C-MOS-Transfergate gebildet sind ; diese Breitbandsignal-Raumkoppeleinrichtung ist erfindungsgemäß dadurch gekennzeichnet, daß dem Nutzsignaleingang des C-MOS-Transfergates eine C-MOS-Inverterschaltung vorgeschaltet ist.

Es sei an dieser Stelle bemerkt, daß es (aus JP-A-57-193125) bei einer mit einem vorgeschalteten C-MOS-Inverter versehenen ternären Bufferschaltung mit einem Inverter, einem NAND-Glied, einem NOR-Glied und einem C-MOS-Inverter bekannt ist, den Platzaufwand zu verringern und die Schnelligkeit zu erhöhen, was durch den Ersatz von NAND-Glied, NOR-Glied und C-MOS-Inverter durch ein Transfergate und die damit verbundene Verringerung der Transistor-Anzahl erreicht wird, wobei der der genannte vorgeschaltete C-MOS-Inverter beibehalten ist. Ein solcher Weg einer Verringerung der Transistor-Anzahl wird von der Erfindung gerade nicht gegangen.

Die Erfindung bringt neben dem Vorteil einer vollständigen Entkopplung von Ausgangs- und Eingangsleitungen und der daraus resultierenden Eliminierung von Übersprechproblemen den weiteren Vorteil einer hohen Arbeitsgeschwindigkeit mit sich, da zum einen Rückwirkungen der Ausgangsleitungskapazität auf die Eingangsleitung vermieden werden und zum anderen zwar die Inverterlaufzeit hinzukommt, zugleich aber die Inverterschaltung, als Treiberpuffer für die Ausgangsleitung wirkend, die Flankensteilheit der durchgeschalteten Signale merklich vergrößert.

Weitere Besonderheiten der Erfindung werden aus der nachfolgenden näheren Erläuterung der Erfindung anhand der Zeichnung ersichtlich.

Dabei zeigen

FIG 1 schematisch ein Ausführungsbeispiel einer Breitbandkoppelanordnung und

FIG 2 Einzelheiten ihrer schaltungstechnischen Realisierung gemäß der Erfindung.

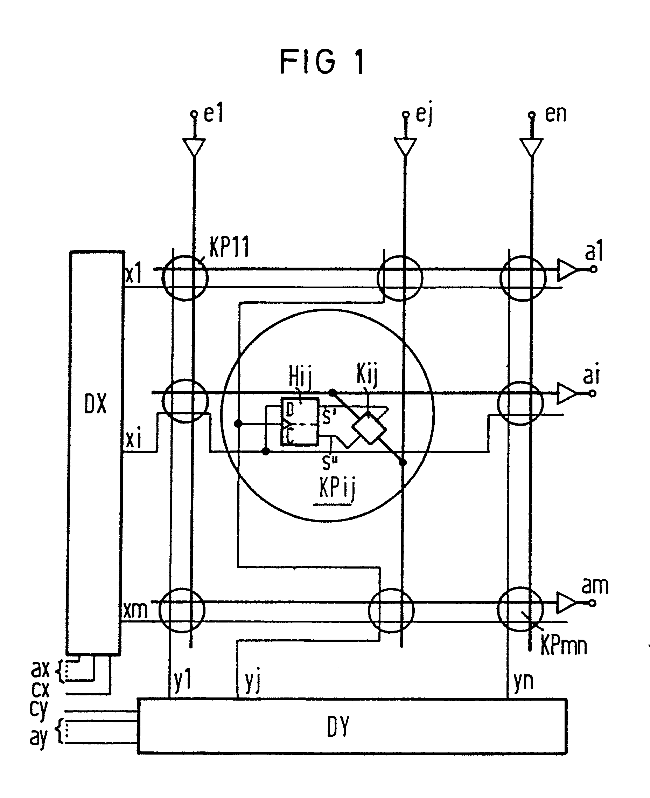

In der Zeichnung FIG 1 ist schematisch in einem zum Verständnis der Erfindung erforderlichen Umfange eine Breitbandsignal-Raumkoppeleinrichtung skizziert. Diese Raumkoppeleinrichtung weist eine Koppelpunktmatrix mit Koppelpunkten KPII...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert werden ; diese Haltespeicherzelle Hij (beim Koppelpunkt KPij) ist durch ein bistabiles D-Kippglied gebildet, dessen beide Ausgänge s' und s" zu entsprechenden Steuereingängen des jeweiligen Koppelelements (Kij beim Koppelpunkt KPij) führen.

Die Halte-Speicherzellen ... Hij... werden ihrerseits durch zwei Ansteuerdecoder, nämlich einen Zeilendecoder DX und einen Spaltendecoder DY, über entsprechende Ansteuerleitungen xl...xi...xm ; yl...yj...yn in zwei Koordinaten angesteuert ; dabei ist der in Zeilenrichtung ansteuernde Decoder DX mit seinem jeweiligen Decoderausgang ...xi... an die D-Eingänge D der in der betreffenden Matrixzeile, im Beispiel in der i-ten-Zeile, angeordneten D-Kippglieder ...Hij... geführt, während der in Spaltenrichtung ansteuernde Decoder DY mit seinem jeweiligen Decoderausgang ...yj... an die Clock-Eingänge C der in der betreffenden Matrixspalte, beispielsweise in der j-ten Spalte, angeordneten D-Kippglieder ..Hij.. geführt ist.

Wie dies aus FIG 1 ersichtlich ist, mögen die beiden Ansteuerdecoder DX, DY über Eingangsleitungen ax, ay jeweils mit einer einer Matrixreihe (Zeile bzw. Spalte) von Koppelpunkten gemeinsamen Koppelpunktzeilen- bzw. Koppelpunktspalten-Adresse und über Eingangsleitungen cx, cy jeweils mit einem Adreßtaktsignal beaufschlagbar sein, auf die hin sie jeweils an der der jeweiligen Koppelpunktreihen-Adresse entsprechenden Ansteuerleitung zeitgerecht jeweils ein Ansteuersignal abgeben.

Das Zusammentreffen eines Zeilenansteuersignals und eines Spaltenansteuersignals am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Halte-Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, genügt die Abgabe allein eines entsprechenden Spaltenansteuersignals durch den Spaltendecoder DY über dessen Ansteuerleitung yj, ohne daß der Zeilendecoder DX über seine Zeilenansteuerleitung xi ein Ansteuersignal abgibt ; das allein am Clock-Eingang C der zum Koppelpunkt Kpij gehörenden Halte-Speicherzelle Hij auftretende Steuersignal bewirkt dann die Rücksetzung der Halte-Speicherzelle Hij mit der Folge, daß das von ihr gesteuerte Koppelelement Kij gesperrt wird.

Die einzelnen Halte-Speicherzellen ...Hij... mögen jeweils an ihrem Ausgang s' jeweils ein dem einen Speisepotential $U_{DD}$ (+5 V) von C-MOS-Schaltungen entsprechendes ($U_{DD}$-)Signal oder ein dem anderen Speisepotential $U_{SS}$ (Masse) von C-MOS-Schaltungen entsprechendes ($U_{SS}$-)Signal abgeben und an ihrem anderen Ausgang s" das jeweils andere ($U_{SS}$-bzw. $U_{DD}$-)Signal. Auf weitere Einzelheiten der schaltungstechnischen Realisierung der Halte-Speicherzellen ...Hij... braucht hier nicht eingegangen zu werden, da dies zum Verständnis der Erfindung nicht erforderlich ist ; solche Einzelheiten sind im übrigen bereits an anderer Stelle (DE-P 35 33 915.2) angegeben.

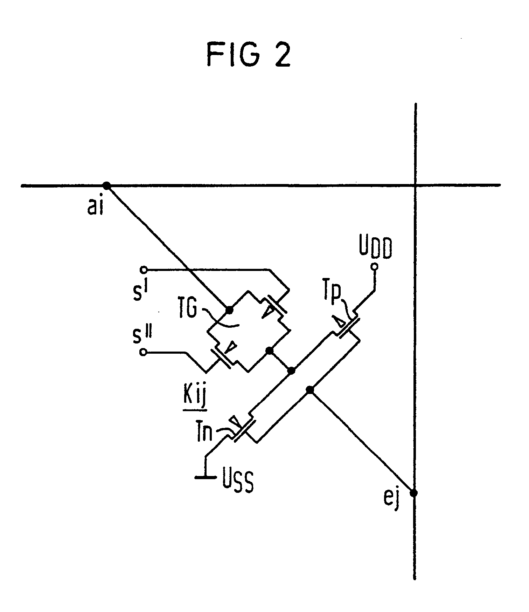

Einzelheiten der schaltungstechnischen Realisierung der Koppelelemente ...Kij... zeigt FIG 2. Gemäß FIG 2 weist ein solches Koppelelement zunächst einmal ein an sich (z.B. aus McMOS Handbook, 1973, Seite 3.9, Fig. 11) bekanntes C-MOS-Transfergate TG auf, wobei dann dem (Nutz-)Signaleingang des C-MOS-Transfergates TG eine C-MOS-Inverterschaltung Tp, Tn vorgeschaltet ist. Der Eingang ej der C-MOS-Inverterschaltung Tp, Tn und damit auch derjenige des Koppelelements Kij ist mit der zugehörigen Eingangsleitung der Koppelpunktmatrix verbunden, deren Eingangsleitungen in FIG 1 mit el...ej...en bezeichnet sind. Der Ausgang ai des Koppelelements Kij ist mit der zugehörigen Ausgangsleitung der Koppelpunktmatrix verbunden, deren Ausgangsleitungen in FIG 1 mit al...ai...am bezeichnet sind.

Wenn von der Halte-Speicherzelle Hij (in FIG 1) her an den Steuereingang s' des Koppelelements Kij das $U_{SS}$-Potential angeschaltet ist und an den Steuereingang s" das $U_{DD}$-Potential, so ist das Koppelelement Kij im Durchschaltezustand ; am Eingang ej auftretende Digitalsignale gelangen damit, im Inverter verstärkt und invertiert, zum Ausgang ai, wobei gleichzeitig durch den Inverter Tp, Tn eine Rückwirkung vom Ausgang ai auf den Eingang ej unterdrückt wird.

Wenn von der Halte-Speicherzelle Hij (in Fig 1) her an den Steuereingang s' des Koppelelements Kij das $U_{DD}$-Potential angeschaltet ist und an den Steuereingang s" das $U_{SS}$-Potential, so ist das Koppelelement Kij im Sperrzustand (Tristatezustand), so daß keine am Eingang ej auftretenden Signale zum Ausgang ai gelangen. Die Inverterschaltungen der im Sperrzustand befindlichen Koppelelemente der Koppelpunktmatrix KPll...KPij...KPmn (in FIG 1) unterdrücken zugleich ein Übersprechen zwischen Ausgangsleitungen al...ai...am (in FIG 1) und Eingangsleitungen el...ej...en (in FIG 1) über solche gesperrte Koppelpunkte.

## Ansprüche

Breitbandsignal-Koppeleinrichtung mit einer Koppelpunktmatrix, deren jeweils von einer decodergesteuerten, koppelpunktindividuellen Speicherzelle steuerbaren Koppelelemente jeweils mit einem C-MOS-Transfergate gebildet sind, **dadurch gekennzeichnet,** daß dem Nutzsignaleingang des C-MOS-Transfergates (TG) eine C-MOS-Inverterschaltung (Tp, Tn) vorgeschaltet ist.

## Claims

Broadband signal switching device having a switching matrix, the switching elements of which, which are controllable in each case by a decoder-controlled, crosspoint-specific memory cell, are formed in each case by a C-MOS transfer gate, characterized in that a C-MOS inverter circuit (Tp, Tn) is connected upstream of the useful signal input of the C-MOS transfer gate (TG).

## Revendications

Dispositif de couplage pour des signaux à large bande comportant une matrice de points de couplage, dont des points de couplage pouvant être commandés respectivement par une cellule de mémoire commandée par un décodeur et prévue pour chaque point de couplage, sont formés respectivement par une porte de transfert C-MOS, caractérisé par le fait qu'un circuit inverseur C-MOS (Tp, Tn) est branché en amont de l'entrée des signaux utiles de la porte de transfert C-MOS (TG).

# FIG 1

# FIG 2